(19)

Europäisches
Patentamt
European
Patent Office
Office européen
des brevets

(11) **EP 2 492 247 A1**

(12) **EUROPEAN PATENT APPLICATION**
published in accordance with Art. 153(4) EPC

(43) Date of publication:
**29.08.2012 Bulletin 2012/35**

(21) Application number: **10824995.4**

(22) Date of filing: **20.10.2010**

(51) Int Cl.:
*C03C 3/085* (2006.01)    *C03C 3/087* (2006.01)
*C03C 3/091* (2006.01)    *C03C 3/093* (2006.01)
*H01L 31/04* (2006.01)

(86) International application number:
**PCT/JP2010/068526**

(87) International publication number:
**WO 2011/049146 (28.04.2011 Gazette 2011/17)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **20.10.2009 JP 2009241330**

(71) Applicant: **Asahi Glass Company, Limited
Tokyo 100-8405 (JP)**

(72) Inventors:
• **NISHIZAWA Manabu
Tokyo 100-8405 (JP)**
• **KUROKI Yuichi
Tokyo 100-8405 (JP)**

• **NAGASHIMA Tatsuo
Tokyo 100-8405 (JP)**
• **KAWAMOTO Yasushi
Tokyo 100-8405 (JP)**
• **NIKI Shigeru
Tsukuba-shi
Ibaraki 305-8561 (JP)**
• **ISHIZUKA Shogo
Tsukuba-shi
Ibaraki 305-8561 (JP)**

(74) Representative: **Müller-Boré & Partner
Patentanwälte
Grafinger Straße 2
81671 München (DE)**

(54) **GLASS SHEET FOR CU-IN-GA-SE SOLAR CELLS, AND SOLAR CELLS USING SAME**

(57)    Provided are a glass sheet for a CIGS solar cell which satisfies both of high power generation efficiency and high glass transition temperature, and a CIGS solar cell having high power generation efficiency. A glass sheet for a Cu-In-Ga-Se solar cell containing, in terms of mol % on the basis of the following oxides, from 60 to 75 % of $SiO_2$, from 3 to 10 % of $Al_2O_3$, from 0 to 3 % of $B_2O_3$, from 5 to 18 % of MgO, from 0 to 5 % of CaO, from 4 to 18.5 % of $Na_2O$, from 0 to 17 % of $K_2O$, and 0 % or more and less than 10 % of SrO + BaO + $ZrO_2$, wherein $K_2O/(Na_2O + K_2O)$ is from 0 to 0.5, and the glass sheet has a glass transition temperature (Tg) of more than 550°C; and a solar cell containing a glass substrate including a photoelectric conversion layer of Cu-In-Ga-Se and a cover glass disposed on the glass substrate, wherein one or both of the glass substrate and the cover glass are the glass sheet for a Cu-In-Ga-Se solar cell.

*FIG. 1*

EP 2 492 247 A1

## Description

Technical Field

The present invention relates to a solar cell having a photoelectric conversion layer formed between glass sheets. Typically, the present invention relates to a thin film solar cell having a glass substrate and a cover glass, in which a photoelectric conversion layer including, as a main component, an element of the Group 11, Group 13 or Group 16 is formed on the glass substrate.

Background Art

Since Group 11-13 and Group 11-16 compound semiconductors having a chalcopyrite structure and Group 12-16 compound semiconductors of a cubic system or hexagonal system have a large absorption coefficient to light in the visible to near-infrared wavelength range, they are expected as a material for high-efficiency thin film solar cell. Representative examples thereof include $Cu(In,Ga)Se_2$ (hereinafter referred to as "Cu-In-Ga-Se" or "CIGS") and CdTe.
In the CIGS thin film solar cell, in view of the matters that it is inexpensive and that its thermal expansion coefficient is close to that of the CIGS compound semiconductor, a soda lime glass is used as a substrate, and a solar cell is obtained.
Also, in order to obtain a solar cell with good efficiency, a glass material which withstands a heat treatment temperature of high temperatures is proposed (see Patent Document 1).

Prior Art Documents

Patent Document

Patent Document 1: JP-A-11-13519

Summary of the Invention

Problems to be Solved By the Invention

An absorption layer of the CIGS solar cell is formed on the glass substrate; however, as disclosed in Patent Document 1, in order to fabricate a solar cell with good power generation efficiency, a heat treatment at a higher temperature is preferable, and the glass substrate is required to withstand it. In Patent Document 1, a glass composition having a relatively high rate-cooling point is proposed; however, it is not always said that the invention described in Patent Document 1 has high power generation efficiency.
The present inventors discovered that the power generation efficiency could be enhanced by increasing an alkali of a glass substrate in a prescribed range; however, there was a problem that the increase of the amount of alkali brought a lowering of a glass transition temperature (Tg) thereof.
In the light of the above, in the glass substrate to be used for the CIGS solar cell, there was a problem that it is difficult to satisfy both high power generation efficiency and high glass transition temperature.
An object of the present invention is to provide a glass sheet for a CIGS solar cell capable of satisfying both high power generation efficiency and high glass transition temperature and a CIGS solar cell with high power generation efficiency.

Means for Solving the Problems

The present invention provides a glass sheet for a Cu-In-Ga-Se solar cell containing, in terms of mol % on the basis of the following oxides,
from 60 to 75 % of $SiO_2$,
from 3 to 10 % of $Al_2O_3$,
from 0 to 3 % of $B_2O_3$,
from 5 to 18 % of MgO,
from 0 to 5 % of CaO,
from 4 to 18.5 % of $Na_2O$,
from 0 to 17 % of $K_2O$, and
0 % or more and less than 10 % of $SrO + BaO + ZrO_2$,
wherein $K_2O/(Na_2O + K_2O)$ is from 0 to 0.5, and

the glass sheet has a glass transition temperature (Tg) of more than 550°C.

The glass sheet for a Cu-In-Ga-Se solar cell of the present invention preferably includes 0 to 3% of CaO.

In addition, the present invention provides a solar cell comprising a glass substrate including a photoelectric conversion layer of Cu-In-Ga-Se and a cover glass disposed on the glass substrate, wherein one or both of the glass substrate and the cover glass are the glass sheet for a Cu-In-Ga-Se solar cell of the present invention.

Advantages of the Invention

The glass sheet for a Cu-In-Ga-Se solar cell of the present invention is able to satisfy both high power generation efficiency and high glass transition temperature, and a solar cell with high efficiency is obtainable at low costs.

Brief Description of the Drawing

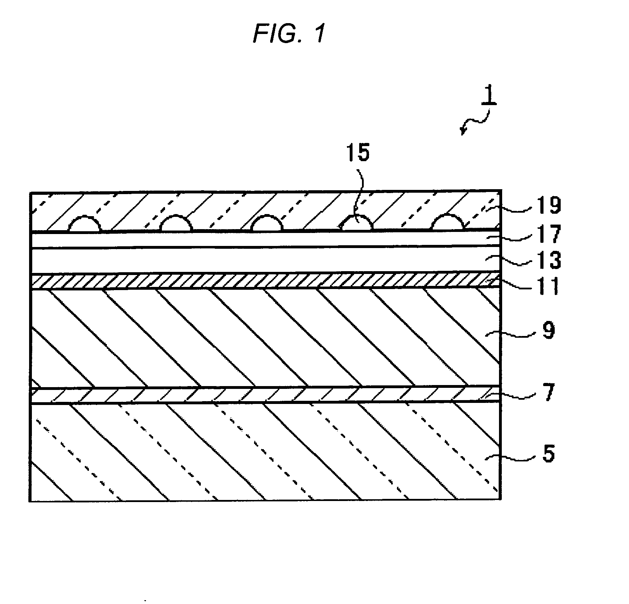

[FIG. 1] FIG. 1 is a cross-sectional view schematically showing an example of embodiments of a solar cell of the present invention.

Modes for Carrying Out the Invention

The glass sheet for a Cu-In-Ga-Se solar cell of the present invention is hereunder described.

The glass sheet for a Cu-In-Ga-Se solar cell of the invention includes, in terms of mol % on the basis of the following oxides,
from 60 to 75 % of $SiO_2$,
from 3 to 10 % of $Al_2O_3$,
from 0 to 3 % of $B_2O_3$,
from 5 to 18 % of MgO,
from 0 to 5 % of CaO,
from 4 to 18.5 % of $Na_2O$,
from 0 to 17 % of $K_2O$, and
0 % or more and less than 10 % of $SrO + BaO + ZrO_2$,
wherein $K_2O/(Na_2O + K_2O)$ is from 0 to 0.5, and
the glass sheet has a glass transition temperature (Tg) of more than 550°C. The Cu-In-Ga-Se is hereinafter referred to as "CIGS".

The glass transition temperature (Tg) of the glass sheet for a CIGS solar cell of the present invention is more than 550°C. The glass transition temperature of the glass sheet for a CIGS solar cell of the present invention is higher than a glass transition temperature of soda lime glass. For the purpose of ensuring the formation of a photoelectric conversion layer at high temperatures, the glass transition temperature (Tg) of the glass sheet for a CIGS solar cell of the present invention is preferably 570°C or higher, more preferably 600°C or higher, and still more preferably 610°C or higher.

In the glass sheet for a CIGS solar cell of the present invention, in particular, in the case where the glass sheet for a CIGS solar cell of the present invention is a glass substrate, an average linear expansion coefficient at from 50 to 350°C thereof is preferably from $70 \times 10^{-7}$ to $110 \times 10^{-7}$/°C. When it is less than $70 \times 10^{-7}$/°C or exceeds $110 \times 10^{-7}$/°C, a difference in thermal expansion from the CIGS film is excessively large, so that defects such as exfoliation are easily caused. It is more preferably from $75 \times 10^{-7}$/°C to $105 \times 10^{-7}$/°C, still more preferably from $80 \times 10^{-7}$ to $100 \times 10^{-7}$/°C, and especially preferably from $83 \times 10^{-7}$ to $95 \times 10^{-7}$/°C.

A specific gravity of the glass sheet for a CIGS solar cell of the present invention is preferably 2.7 or less, more preferably 2.6 or less, and still more preferably 2.55 or less.

A temperature $T_2$ at which a viscosity of glass of the glass sheet for a CIGS solar cell of the present invention becomes $10^2$ dPa·s is preferably 1,700°C or less, more preferably 1,650°C or less, and still more preferably 1,600°C or less.

A temperature $T_4$ at which a viscosity of glass of the glass sheet for a CIGS solar cell of the present invention becomes $10^4$ dPa·s is preferably 1,300°C or less, more preferably 1,250°C or less, still more preferably 1,220°C or less, and especially preferably 1,200°C or less.

In the glass sheet for a CIGS solar cell of the present invention, in particular, in the case where the glass sheet for a CIGS solar cell of the present invention is a glass substrate, an alkali elution amount thereof is preferably 0.15 or more, and more preferably 0.2 or more, in terms of a calculated value of an Na/In intensity ratio by the secondary ion mass spectrometry (SIMS).

Also, in the glass sheet for a CIGS solar cell of the present invention, in particular, in the case where the glass sheet for a CIGS solar cell of the present invention is a glass substrate, an alkali elution amount thereof is preferably 1E+20 or more, more preferably 1.5E+20 or more, still more preferably 2.0E+20 or more, and especially preferably 2.5E+20 or more, in terms of an amount of Na (unit: atoms/cc) in an Mo film by SIMS. Also, an amount of K (unit: atoms/cc) in an Mo film by SIMS is preferably 1E+18 or more, more preferably 1E+19 or more, still more preferably 3E+19 or more, and especially preferably 5E+19 or more.

The reasons why the glass sheet for a CIGS solar cell of the present invention is limited to the foregoing composition are as follows.

$SiO_2$: $SiO_2$ is a component for forming a skeleton of glass, and when its content is less than 60 mol % (hereinafter referred to simply as "%"), there is a concern that the heat resistance and chemical durability of the glass are lowered, and the thermal expansion coefficient increases. But, when it exceeds 75 %, there is a concern that the viscosity at a high temperature of the glass increases, and a problem that the fusibility is deteriorated is caused. The content thereof is preferably from 63 to 72 %, more preferably from 63 to 70 %, and still more preferably from 63 to 69 %.

$Al_2O_3$: $Al_2O_3$ increases the glass transition temperature, enhances the weather resistance (solarization), heat resistance and chemical durability, and increases a Young's modulus. When its content is less than 3 %, there is a concern that the glass transition temperature is lowered. Also, there is a concern that the thermal expansion coefficient increases. But, when it exceeds 10 %, there is a concern that the viscosity at a high temperature of glass increases, and the fusibility is deteriorated. Also, there is a concern that the devitrification temperature increases, and the formability is deteriorated. Also, there is a concern that the power generation efficiency is lowered, namely, an alkali elution amount as described later is lowered. The content thereof is preferably from 4 to 9 %, and more preferably from 5 to 8 %.

$B_2O_3$: $B_2O_3$ may be contained in an amount of up to 3 % for the purposes of enhancing the fusibility, etc. When its content exceeds 3 %, the glass transition temperature decreases, or the thermal expansion coefficient becomes small, and thus is not preferable for a process for forming the CIGS film. The content thereof is more preferably 2 % or less, and is especially preferably 1.5 % or less.

When a total content of $SiO_2$, $Al_2O_3$ and $B_2O_3$ is high, elution of the alkali is hindered, and therefore, it is preferable that the total content is low. The total content of $SiO_2$, $Al_2O_3$ and $B_2O_3$ is suitably 80 % or less, preferably 78 % or less, more preferably 75 % or less, and still more preferably 73 % or less.

MgO: MgO is contained because it has effects for decreasing the viscosity during melting of glass, and promoting melting. But, when its content is less than 5 %, there is a concern that the viscosity at a high temperature of glass increases, and the fusibility is deteriorated. Also, there is a concern that the power generation efficiency is lowered, namely, an alkali elution amount as described later is lowered. But, when it exceeds 18 %, there is a concern that the thermal expansion coefficient increases. Also, there is a concern that the devitrification temperature increases. The content thereof is preferably 6 to 16 %, more preferably from 7 to 14 %, and still more preferably from 8 to 12 %.

CaO: CaO can be contained because it has effects for decreasing the viscosity during melting of glass, and promoting melting. But, when its content exceeds 5 %, there is a concern that the power generation efficiency is lowered, namely, an alkali elution amount as described later is lowered, and the thermal expansion coefficient of the glass sheet increases. The content thereof is preferably 3 % or less, more preferably 2 % or less, and still more preferably 1 % or less.

SrO: SrO can be contained because it has effects for decreasing the viscosity during melting of glass, and promoting melting. But, when its content exceeds 5 %, there is a concern that the power generation efficiency is lowered, namely, an alkali elution amount as described later is lowered, and the thermal expansion coefficient of the glass sheet increases. The content thereof is preferably 4 % or less, and more preferably 3 % or less.

BaO: BaO can be contained because it has effects for decreasing the viscosity during melting of glass, and promoting melting. But, when its content exceeds 4 %, there is a concern that the power generation efficiency is lowered, namely, an alkali elution amount as described later is lowered, and the thermal expansion coefficient of the glass sheet increases. The content thereof is preferably 3 % or less, and more preferably 2 % or less.

$ZrO_2$: $ZrO_2$ can be contained because it has effects for decreasing the viscosity during melting of glass, increasing the power generation efficiency, and promoting melting. But, when its content exceeds 4 %, there is a concern that the power generation efficiency is lowered, namely, an alkali elution amount as described later is lowered, and the thermal expansion coefficient of the glass sheet increases. The content thereof is preferably 3 % or less.

SrO, BaO and $ZrO_2$ decrease the viscosity at a melting temperature of glass and make it easy to perform melting, and therefore, they are contained in an amount of from 0 to 10 % in total. But, when the total content exceeds 10 %, there is a concern that the power generation efficiency is lowered, namely, an alkali elution amount as described later is lowered, and the glass transition temperature is lowered, and the thermal expansion coefficient of glass increases. The total content of SrO, BaO and $ZrO_2$ is preferably 1 % or more, and more preferably 2 % or more. It is preferably less than 10 %, more preferably 9 % or less, and still more preferably 8 % or less.

Furthermore, it has also been found that when a total amount of SrO, BaO, $ZrO_2$ and $K_2O$ is high, the satisfaction of both high power generation efficiency and high glass transition temperature is affected.

$Na_2O$: $Na_2O$ is a component which contributes to an enhancement of the conversion efficiency of the CIGS solar cell and is an essential component. Also, $Na_2O$ has effects for decreasing the viscosity at a melting temperature of glass and making it easy to perform melting, and therefore, it is contained in an amount of from 4 to 18.5 %. Na is diffused into the absorption layer of the CIGS solar cell constituted on the glass and enhances the conversion efficiency;

however, when its content is less than 4 %, there is a concern that the diffusion of Na into the absorption layer of the CIGS solar cell on the glass is insufficient, and the conversion efficiency is also insufficient. The content is preferably 5 % or more; the content thereof is more preferably 6 % or more; the content thereof is still more preferably 7 % or more; and the content thereof is especially preferably 10 % or more.

When the content of $Na_2O$ exceeds 18.5 %, the thermal expansion coefficient becomes large, and the chemical durability is deteriorated. The content thereof is preferably 17.5 % or less; the content thereof is more preferably 16.5 % or less; the content thereof is still more preferably 15.5 % or less; and the content thereof is especially preferably 14 % or less.

$K_2O$: $K_2O$ has the same effects as those in $Na_2O$, and therefore, it is contained in an amount of from 0 to 17 %. But, when its content exceeds 17 %, there is a concern that the power generation efficiency is lowered, namely, an alkali elution amount as described later is lowered, the glass transition temperature is lowered, and the thermal expansion coefficient of the glass sheet becomes large. In the case where $K_2O$ is contained, its content is preferably 1 % or more. The content thereof is preferably 12 % or less, more preferably 9 % or less, and still more preferably 7 % or less.

$Na_2O$ and $K_2O$: For the purpose of sufficiently decreasing the viscosity at a melting temperature of glass, a value of a ratio of the content of $K_2O$ to a total content of $Na_2O$ and $K_2O$ $[K_2O/(Na_2O + K_2O)]$ is set to from 0 to 0.5. When this value exceeds 0.5, there is a concern that the power generation efficiency is lowered, namely, an alkali elution amount as described later is lowered, the thermal expansion coefficient increases, and the melting properties are lowered. The $K_2O/(Na_2O + K_2O)$ is preferably 0.1 or more. The $K_2O/(Na_2O + K_2O)$ is preferably 0.45 or less, more preferably 0.4 or less, and still more preferably 0.35 or less.

$Na_2O$ and $K_2O$ are contained in an amount of preferably from 13 to 20 %, more preferably 19.5 % or less, still more preferably 19 % or less, and especially preferably 18.5 % or less, in total. The total content of $Na_2O$ and $K_2O$ is more preferably 14 % or more, and still more preferably 15 % or more.

A value of a ratio of the total content of $Na_2O$ and $K_2O$ to the total content of $SiO_2$, $Al_2O_3$ and $B_2O_3$ $[(Na_2O + K_2O)/(SiO_2 + Al_2O_3 + B_2O_3)]$ is preferably large because the elution of an alkali is promoted. The $(Na_2O + K_2O)/(SiO_2 + Al_2O_3 + B_2O_3)$ is preferably 0.15 or more, more preferably 0.18 or more, still more preferably 0.20 or more, and especially preferably 0.22 or more.

Though the glass sheet for a CIGS solar cell of the present invention is essentially composed of the foregoing base composition, it may contain other components typically in an amount of 5 % or less in total within the range where the object of the present invention is not impaired. For example, there may be the case where ZnO, $Li_2O$, $WO_3$, $Na_2O_5$, $V_2O_5$, $Bi_2O_3$, $MoO_3$, $P_2O_5$, etc. may be contained for the purpose of improving the weather resistance, fusibility, devitrification, ultraviolet ray shielding, etc.

Also, for the purpose of improving the melting properties and clarity of glass, $SO_3$, F, Cl, and $SnO_2$ may be added in the base composition material such that these materials are contained in an amount of 2 % or less in total in the glass.

Also, for the purpose of enhancing the chemical durability of glass, $ZrO_2$, $Y_2O_3$, $La_2O_3$, $TiO_2$, and $SnO_2$ may be contained in an amount of 5 % or less in total in the glass. Of these, $Y_2O_3$, $La_2O_3$, and $TiO_2$ also contribute to an enhancement of a Young's modulus of glass. Also, $TiO_2$ is also able to contribute to an enhancement of the power generation efficiency.

Also, for the purpose of adjusting the color tone of glass, colorants such as $Fe_2O_3$ may be contained in the glass. A content of such colorants is preferably 1 % or less in total.

Also, taking an environmental load into consideration, it is preferable that the glass sheet for a CIGS solar cell of the present invention does not substantially contain $As_2O_3$ and $Sb_2O_3$. Also, taking the stable achievement of float forming into consideration, it is preferable that the glass sheet for a CIGS solar cell of the present invention does not substantially contain ZnO.

A manufacturing method of the glass sheet for a CIGS solar cell of the present invention is described. In the case of manufacturing the glass sheet for a CIGS solar cell of the present invention, similar to the case of manufacturing conventional glass sheets for a solar cell, a melting/clarifying step and a forming step are carried out. Since the glass sheet for a CIGS solar cell of the present invention is an alkali glass substrate containing an alkali metal oxide ($Na_2O$ and $K_2O$), $SO_3$ can be effectively used as a refining agent, and a float process is suitable as the forming method.

In the manufacturing step of a glass sheet for a solar cell, it is preferable to adopt, as a method for forming a glass into a sheet form, a float process in which a glass sheet with a large area can be formed easily and stably with an increase in size of solar cells.

A preferred embodiment of the manufacturing method of the glass sheet for CIGS solar cell of the present invention is described.

First of all, a molten glass obtained by melting raw materials is molded into a sheet form. For example, raw materials are prepared so as to have a composition of the glass sheet to be obtained, and the raw materials are continuously thrown into a melting furnace, followed by heating at from about 1,450 to 1,650°C to obtain a molten glass. Then, this molten glass is formed into a glass sheet in a ribbon form by applying, for example, a float process.

Subsequently, the glass sheet in a ribbon form is taken out from the float forming furnace, followed by cooling to a room temperature state by cooling means, and cutting to obtain a glass sheet for a CIGS solar cell.

In the manufacturing step of a solar cell, during the film formation of an electrode film of Mo, etc. or an under layer thereof (for example, $SiO_2$, etc.), or the like on a glass substrate surface, if the glass substrate surface is stained, there is a concern that the film formation cannot be normally achieved, and therefore, it is preferable to clean up the glass sheet. Though the cleaning method is not particularly limited, exemplifications thereof include cleaning with water, cleaning with a cleaning agent, cleaning by rubbing using a brush, etc. while spraying a cerium oxide-containing slurry, and so on. In the case of performing cleaning with a cerium oxide-containing slurry, it is preferable to subsequently perform cleaning using an acidic cleaning agent such as hydrochloric acid and sulfuric acid. It is preferable that the glass sheet surface after cleaning is free from unevenness on the glass sheet surface due to stains or an extraneous matter of the cerium oxide, or the like. This is because if the unevenness is present, there is a concern that, during the film formation, unevenness on the film surface, a deviation in the film thickness, a pinhole of the film, or the like are occurred, and the power generation efficiency is lowered. The unevenness is preferably 20 nm or less in terms of a difference in height.

In the glass sheet for a CIGS solar cell of the present invention, an alkali elution amount (an Na/In intensity ratio as described later) is preferably 0.15 or more, and more preferably 0.2 or more.

The glass sheet for a CIGS solar cell of the present invention is suitable as a glass substrate or cover glass for CIGS solar cell.

In the case of applying the glass sheet for a CIGS solar cell of the present invention to a glass substrate, a thickness of the glass substrate is preferably 3 mm or less, and more preferably 2 mm or less. Also, a method for imparting a photoelectric conversion layer of CIGS to the glass substrate is not particularly limited. When forming a photoelectric conversion layer, a heating temperature can be set to from 500 to 650°C.

In the case of using the glass sheet for a CIGS solar cell of the present invention for only a glass substrate, a cover glass and the like are not particularly limited. As other examples of a composition of the cover glass, soda line glass and so on are exemplified.

In the case of using the glass sheet for a CIGS solar cell of the present invention as a cover glass, a thickness of the cover glass is preferably 3 mm or less, and more preferably 2 mm or less. Also, a method for assembling the cover glass in a glass substrate having a photoelectric conversion layer is not particularly limited. In the case of assembling upon heating, its heating temperature can be set to from 500 to 650°C.

When the glass sheet for a CIGS solar cell of the present invention is used for both a glass substrate and a cover glass for CIGS solar cell, since the thermal expansion coefficient is equal, thermal deformation or the like is not generated during assembling, and thus is preferable.

Next, the solar cell of the present invention is described.

The solar cell of the present invention has a glass substrate having a photoelectric conversion layer of Cu-In-Ga-Se and a cover glass disposed on the glass substrate, and one or both of the glass substrate and the cover glass are the glass sheet for a Cu-In-Ga-Se solar cell of the present invention.

The solar cell of the present invention is hereunder described in detail by reference to the accompanying drawing. It should not be construed that the present invention is limited to the accompanying drawing.

FIG. 1 is a cross-sectional view schematically showing an example of embodiments of the solar cell of the present invention.

In FIG. 1, the solar cell (CIGS solar cell) 1 of the present invention has a glass substrate 5, a cover glass 19, and a CIGS layer 9 between the glass substrate 5 and the cover glass 19. The glass substrate 5 is preferably composed of the glass sheet for a CIGS solar cell of the present invention as described above. The solar cell 1 has a back electrode layer of an Mo film that is a plus electrode 7 on the glass substrate 5, on which a light absorption layer (photoelectric conversion layer) that is the CIGS layer 9 is provided. As the composition of the CIGS layer, $Cu(In_{1-x}Ga_x)Se_2$ can be exemplified. x represents a composition ratio of In and Ga and satisfies a relation of $0 < x < 1$. A transparent conductive film 13 of ZnO or ITO is provided as a buffer layer 11 on the CIGS layer 9 through a CdS (cadmium sulfide) or ZnS (zinc sulfide) layer, and an extraction electrode such as an Al electrode (aluminum electrode) that is a minus electrode 15, etc. is provided thereon. An antireflection film may be provided between these layers in a necessary place. In FIG. 1, an antireflection film 17 is provided between the transparent conductive film 13 and the minus electrode 15.

Also, the cover glass 19 may be provided on the minus electrode 15, and if necessary, a gap between the minus electrode and the cover glass is sealed with a resin or adhered with a transparent resin for adhesion. The glass sheet for a CIGS solar cell of the present invention may be used for the cover glass.

In the present invention, end parts of the photoelectric conversion layer or end parts of the solar cell may be sealed. Examples of a material for sealing include the same materials as those in the glass sheet for a CIGS solar cell of the present invention and the other glasses and resins.

It should not be construed that a thickness of each layer of the solar cell shown in the accompanying drawing is limited to that shown in the drawing.

The cell efficiency of the solar cell of the present invention is higher than the cell efficiency of the CIGS solar cell using a substrate for plasma display as shown in Patent Document 1. Specifically, in the solar cell (CIGS solar cell) of the present invention, the cell efficiency as measured according to the procedures described in the Examples as described later is preferably 14.0 % or more, more preferably 14.5 % or more, still more preferably 15.0 % or more, yet still more preferably 15.5 % or more, and especially preferably 16.0 % or more.

In the solar cell of the present invention, an open circuit voltage (Voc) as measured according to the procedures described in the Examples as described later is preferably 0.6 $V/cm^2$ or more, more preferably 0.63 $V/cm^2$ or more, and still more preferably 0.65 $V/cm^2$ or more. Also, a short-circuit current density (Jsc) as measured according to the procedures described in the Examples as described later is preferably 28.5 $mA/cm^2$ or more, more preferably 30 $mA/cm^2$ or more, and still more preferably 31 $mA/cm^2$ or more. Also, a fill factor (FF) as measured according to the procedures described in the Examples as described later is preferably 0.62 or more, more preferably 0.65 or more, and still more preferably 0.68 or more.

Examples

The present invention is hereunder described in more detail with reference to the following Examples and Manufacturing Examples, but it should not be construed that the present invention is limited to these Examples and Manufacturing Examples.

Examples (Examples 1, 2, and 5 to 29) and Comparative Examples (Examples 3 and 4) of the glass sheet for the CIGS solar cell of the present invention are described. The numerical values in the parentheses in the tables are a calculated value.

Raw materials of respective components were made up so as to have a composition shown in Tables 1 to 6, a sulfate was added to the raw materials in an amount of 0.1 parts by mass as converted into $SO_3$ amount based on 100 pats by mass of the glass, followed by heating and melting at 1,600°C for 3 hours using a platinum crucible. In melting, a platinum stirrer was added, and stirring was performed for one hour, thereby homogenizing the glass. Subsequently, the molten glass was flown out and formed into a sheet form, followed by cooling.

With respect to the thus obtained glass, an average thermal expansion coefficient (unit: $\times 10^{-7}/°C$), a transition temperature Tg (unit: °C), a specific gravity, a temperature $T_2$ (unit: °C) as a reference temperature for melting, at which the viscosity of glass reached $10^2$ dPa·s, a temperature $T_4$ (unit: °C) as a reference temperature for forming, at which the viscosity of glass reached $10^4$ dPa·s, a devitrification temperature (unit: °C), and an alkali elution amount as described below were measured and shown in Tables 1 to 6. Measuring methods of the respective physical properties are shown below.

Tg: Tg is a value as measured using TMA and was determined in conformity with JIS R3103-3 (2001).

Average thermal expansion coefficient at from 50 to 350°C: The average thermal expansion coefficient was measured using a differential thermal expansion meter (TMA) and determined in conformity with JIS R3102 (1995).

Alkali elusion amount (1): ITO having a thickness of 100 nm is film-formed on a glass substrate (square of 40 mm in length and 40 mm in width, thickness: 2 mm) by means of sputtering. Subsequently, the sample is subjected to heat treatment in an electric furnace by holding at 550°C for 30 minutes in an air atmosphere. The sample is measured for an integrated intensity of whole In and whole Na in the ITO film by the secondary ion mass spectrometry (SIMS). A bleeding amount of the alkali is evaluated in terms of an Na/In intensity ratio.

Alkali elution amount (2): An Na concentration or a K concentration in an Mo electrode film (first film to be film-formed on the glass substrate) of a CIGS cell as fabricated according to the procedures as described later was quantitatively determined by means of SIMS.

$T_2$ and $T_4$: A viscosity was measured using a rotary viscometer. A temperature $T_2$ at which the viscosity reached $10^2$ dPa·s and a temperature $T_4$ at which the viscosity reached $10^4$ dPa·s were measured.

Specific gravity: A foam-free glass block of about 20 g was measured by the Archimedian method.

Devitrification temperature: Glass particles were put on a platinum-made dish, followed by subjecting to heat treatment for 17 hours in an electric furnace controlled at a fixed temperature. After the heat treatment, optical microscopic observation was performed, and an average value of a maximum temperature at which a crystal was deposited on the glass and a minimum temperature at which a crystal was not deposited on the glass was defined as the devitrification temperature.

An $SO_3$ residual amount in the glass was from 100 to 500 ppm.

Also, using each of the glass sheets for the solar cell of Examples (Examples 1, 2, and 5 to 29) and Comparative Examples (Examples 3 and 4), a CIGS solar cell was fabricated according to the following procedures, and the cell efficiency was measured and shown in Tables 1 to 6.

[Manufacturing procedures of CIGS solar cell]

The fabricated glass substrate was processed in a size of about 3 cm $\times$ 3 cm square and a thickness of from 1 to 3 mm, on which a molybdenum film was then film-formed by means of sputtering. As to the film formation condition, the molybdenum film having a film thickness of from 500 to 1,000 nm was formed by heating at 120°C before the film formation.

Thereafter, the substrate with the molybdenum film was heated at 200°C for 30 minutes before the film formation in a sample exchange chamber of a multi-source vapor deposition apparatus, and a CIGS layer was then film-formed by adopting a three-stage process. As to the film formation condition, the film was formed at a substrate temperature of from 400 to 550°C so as to have a film thickness of 1.8 $\mu$m or more.

In the three-stage process, the multi-source vapor deposition apparatus is used, and at a first stage, heating is performed until the substrate temperature reaches about 400°C, thereby forming an In-Ga-Se film. Thereafter, at a second stage, the substrate temperature is started to be increased to 500 to 550°C, and Cu and Se are then supplied until the composition of the whole of the film becomes excessive in Cu. Furthermore, at a third stage, In, Ga and Se are again supplied, thereby achieving the film formation such that the final composition becomes excessive in In and Ga (Cu/(In + Ga) ratio < 1), and the film thickness is 1.8 $\mu$m or more.

Thereafter, the substrate with the CIGS film was dipped for washing in a potassium cyanide solution having a concentration of 10 % for 60 seconds, thereby removing a CuSe layer that is a cause of a leakage current.

On the CIGS film, a CdS layer was film-formed by the CBD (chemical bath deposition) process. As to the film formation condition, an aqueous solution containing 0.015 M cadmium sulfate, 1.5 M thiourea, and 15 M ammonia was used, and a CdS film was formed in a thickness of from 50 to 100 nm.

On the CdS film, ZnO and AZO layers were film-formed using a ZnO target and an AZO target (ZnO target containing 1.5 wt% of $Al_2O_3$) by means of sputtering. ZnO and AZO were film-formed in a thickness of about 100 nm and about 200 nm, respectively.

An aluminum electrode was film-formed on the AZO film by means of heating vapor deposition method.

Thereafter, the resultant was shaven to the point of the CIGS layer by using a pointed metal sheet to leave the molybdenum lower electrode, thereby forming a cell. Thereafter, the fabrication of a lower electrode was performed, thereby fabricating a CIGS solar cell in which each four cells having a fixed area (an area exclusive of the aluminum electrode was about 0.5 $cm^2$) were arranged on the both sides, i.e., eight cells in total were arranged.

[Measurement of cell efficiency of CIGS solar cell]

The CIGS solar cell was disposed in a box of about 30 cm per one side for shielding external light and colored black as far as possible for the purpose of suppressing internal reflection light; and a plus terminal for the molybdenum lower electrode previously coated with an InGa solvent (for the ohmic contact) and a minus terminal for the aluminum upper extraction electrode on the surfaces of the eight cells were respectively connected to a voltage/current generator. The temperature within the box was controlled constant at 25°C by a temperature regulator. The external light was shielded from the inside of the box; a xenon lamp was irradiated for 10 seconds from the upper portion of the solar cell; thereafter, the resulting solar cell was held for 60 seconds until the temperature of the solar cell became stable; and the voltage was changed from -1 V to +1 V at intervals of 0.015 V at the time of non-irradiation and the time of irradiation, thereby measuring a current value. The cell efficiency was calculated from the current and voltage characteristics during the irradiation. Among the eight cells, a value of the cell exhibiting the best efficiency is shown in each of the tables.

The cell efficiency is determined from an open circuit voltage (Voc), a short-circuit current density (Jsc), and a fill factor (FF) according to the following formula (1).

$$\text{Cell efficiency } [\%] = \text{Voc } [\text{V}] \times \text{Jsc } [\text{A/cm}^2] \times \text{FF (dimensionless)} \times 100/(\text{Illuminance of light source used for the test}) \; [\text{W/cm}^2] \quad (1)$$

Here, the open circuit voltage (Voc) is an output when opening the terminal; the short-circuit current density (Jsc) is one obtained by dividing a short-circuit current (Isc) that is a current when short-circuiting the terminal, by an effective area; and the fill factor (FF) is one obtained by dividing the product of a voltage at a maximum output point that is a point at which a maximum output is given (maximum voltage value (Vmax)) and a current at the maximum output point (maximum current value (Imax)), by the product of the open circuit voltage (Voc) and the short-circuit current (Isc).

[Table 1]

|  |  | Ex. 1 | Ex. 2 | Ex. 3 | Ex. 4 | Ex. 5 |
|---|---|---|---|---|---|---|
| $SiO_2$ | (mol %) | 64.5 | 70.6 | 72.0 | 66.5 | 67.5 |
| $Al_2O_3$ | (mol %) | 6.0 | 3.1 | 1.1 | 4.7 | 5.0 |
| $B_2O_3$ | (mol %) | 0 | 0 | 0 | 0 | 0 |
| MgO | (mol %) | 11.0 | 12.9 | 5.5 | 3.4 | 8.0 |
| CaO | (mol %) | 0 | 0 | 8.6 | 6.2 | 0 |
| SrO | (mol %) | 0 | 0 | 0 | 4.7 | 3.0 |
| BaO | (mol %) | 0 | 0 | 0 | 3.6 | 0 |
| $ZrO_2$ | (mol %) | 2.5 | 0 | 0 | 1.7 | 1.5 |
| $Na_2O$ | (mol %) | 12.0 | 13.4 | 12.6 | 4.8 | 13.0 |
| $K_2O$ | (mol %) | 4.0 | 0 | 0.2 | 4.4 | 2.0 |
| $TiO_2$ | (mol %) | 0 | 0 | 0 | 0 | 0 |
| $SrO+BaO+ZrO_2$ | (mol %) | 2.5 | 0 | 0 | 10.0 | 4.5 |
| $MgO+CaO+SrO+BaO$ | (mol %) | 11.0 | 12.9 | 14.1 | 17.9 | 11.0 |
| $Na_2O+K_2O$ | (mol %) | 16.0 | 13.4 | 12.8 | 9.2 | 15.0 |
| $K_2O/(Na_2O+K_2O)$ |  | 0.25 | 0 | 0.02 | 0.48 | 0.13 |
| $Al_2O_3+SiO_2+B_2O_3$ | (mol %) | 70.5 | 73.7 | 73.1 | 71.2 | 72.5 |
| $(Na_2O+K_2O)/(Al_2O_3+SiO_2+B_2O_3)$ |  | 0.227 | 0.182 | 0.175 | 0.129 | 0.207 |
| Average thermal expansion coefficient ($\times10^{-7}$/°C) |  | 91 | (81) | 85 | 83 | 90 |
| Tg(°C) |  | 630 | (604) | 550 | 620 | 577 |
| Specific gravity |  | 2.53 | (2.45) | 2.50 | 2.77 | (2.56) |
| Alkali elution amount (1) |  | (0.29) | (0.45) | * | (0.14) | (0.36) |
| Alkali elution amount (2) |  |  |  |  |  |  |
| Na amount in Mo film (atoms/cc) |  | 9.9+E20 |  |  | 9.5+E19 | 7.2E+20 |
| K amount in Mo film (atoms/cc) |  | 9.3+E19 |  |  | 2.4+E19 | 5.4E+19 |
| $T_2$(°C) |  | 1575 | (1564) | 1461 | 1551 | (1557) |
| $T_4$(°C) |  | 1168 | (1113) | 1040 | 1141 | (1132) |
| Devitrification temperature (°C) |  | < 1140 |  | 1020 | 1080 | < 1000 |
| Cell efficiency (%) |  | 16.37 | 15.40 |  | 12.91 | 14.24 |
| Voc(V/cm$^2$) |  | 0.67 | 0.65 |  | 0.58 | 0.61 |
| Jsc(mA/cm$^2$) |  | 31.74 | 31.19 |  | 30.80 | 29.94 |
| FF |  | 0.70 | 0.70 |  | 0.66 | 0.66 |

[Table 2]

|  |  | Ex. 6 | Ex. 7 | Ex. 8 | Ex. 9 | Ex. 10 |
|---|---|---|---|---|---|---|
| $SiO_2$ | (mol %) | 62.0 | 66.5 | 68.5 | 68.0 | 68.0 |
| $Al_2O_3$ | (mol %) | 10.0 | 7.0 | 9.0 | 5.0 | 5.0 |
| $B_2O_3$ | (mol %) | 0 | 0 | 1.0 | 0 | 0 |

(continued)

| | | Ex. 6 | Ex. 7 | Ex. 8 | Ex. 9 | Ex. 10 |
|---|---|---|---|---|---|---|
| MgO | (mol %) | 8.0 | 8.0 | 5.0 | 5.0 | 5.0 |
| CaO | (mol %) | 0 | 0 | 0.5 | 3.0 | 3.0 |
| SrO | (mol %) | 0 | 1.0 | 0.5 | 0 | 0 |
| BaO | (mol %) | 0 | 1.0 | 0.5 | 0 | 0 |
| $ZrO_2$ | (mol %) | 3.0 | 1.0 | 0.5 | 2.0 | 2.0 |
| $Na_2O$ | (mol %) | 13.0 | 12.0 | 11.5 | 13.0 | 8.5 |
| $K_2O$ | (mol %) | 4.0 | 3.5 | 3.0 | 4.0 | 8.5 |
| $TiO_2$ | (mol %) | 0 | 0 | 0 | 0 | 0 |
| $SrO+BaO+ZrO_2$ | (mol %) | 3.0 | 3.0 | 1.5 | 2.0 | 2.0 |
| $MgO+CaO+SrO+BaO$ | (mol %) | 8.0 | 10.0 | 6.5 | 8.0 | 8.0 |
| $Na_2O+K_2O$ | (mol %) | 17.0 | 15.5 | 14.5 | 17.0 | 17.0 |
| $K_2O/(Na_2O+K_2O)$ | | 0.24 | 0.23 | 0.21 | 0.24 | 0.50 |
| $Al_2O_3+SiO_2+B_2O_3$ | (mol %) | 72.0 | 73.5 | 78.5 | 73.0 | 73.0 |
| $(Na_2O+K_2O)/(Al_2O_3+SiO_2+B_2O_3)$ | | 0.236 | 0.211 | 0.185 | 0.233 | 0.233 |
| Average thermal expansion coefficient ($\times 10^{-7}$/°C) | | 98 | 99 | 87 | 97 | 99 |
| Tg(°C) | | 676 | 587 | 613 | 563 | 574 |
| Specific gravity | | (2.55) | (2.54) | (2.45) | 2.52 | 2.51 |
| Alkali elution amount (1) | | (0.16) | (0.25) | (0.15) | (0.36) | (0.23) |
| Alkali elution amount (2) | | | | | | |
| Na amount in Mo film (atoms/cc) | | 5.1E+20 | 6.5E+20 | 6.7E+20 | 5.6E+20 | 3.3E+20 |
| K amount in Mo film (atoms/cc) | | 8.0E+19 | 8.3E+19 | 6.9E+19 | 7.6E+19 | 1.3E+20 |
| $T_2$(°C) | | (1619) | (1608) | (1332) | (1583) | (1629) |
| $T_4$(°C) | | (1210) | (1174) | (983) | (1146) | (1198) |
| Devitrification temperature (°C) | | > 1250 | 1125 | < 1000 | < 1000 | < 1000 |
| Cell efficiency (%) | | 14.10 | 14.11 | 14.11 | 15.23 | 14.53 |
| Voc(V/cm$^2$) | | 0.61 | 0.61 | 0.61 | 0.64 | 0.63 |
| Jsc(mA/cm$^2$) | | 30.14 | 29.94 | 29.77 | 30.52 | 30.96 |
| FF | | 0.65 | 0.66 | 0.66 | 0.67 | 0.63 |

[Table 3]

| | | Ex. 11 | Ex. 12 | Ex. 13 | Ex. 14 |
|---|---|---|---|---|---|
| $SiO_2$ | (mol %) | 66.0 | 67.0 | 74.0 | 63.0 |
| $Al_2O_3$ | (mol %) | 9.0 | 6.0 | 5.0 | 10 |
| $B_2O_3$ | (mol %) | 0 | 0 | 0.0 | 0 |
| MgO | (mol %) | 6.0 | 8.0 | 6.0 | 5.0 |
| CaO | (mol %) | 0 | 0 | 0 | 0 |
| SrO | (mol %) | 0 | 0 | 0 | 0 |

(continued)

| | | Ex. 11 | Ex. 12 | Ex. 13 | Ex. 14 |
|---|---|---|---|---|---|
| BaO | (mol %) | 0 | 0 | 0 | 0 |
| $ZrO_2$ | (mol %) | 2.0 | 0 | 0 | 2.0 |
| $Na_2O$ | (mol %) | 17.0 | 13.0 | 11.0 | 10.0 |
| $K_2O$ | (mol %) | 0 | 4.0 | 4.0 | 10.0 |
| $TiO_2$ | (mol %) | 0 | 2.0 | 0.0 | 0.0 |
| $SrO+BaO+ZrO_2$ | (mol %) | 2.0 | 0 | 0.0 | 2.0 |
| $MgO+CaO+SrO+BaO$ | (mol %) | 6.0 | 8.0 | 6.0 | 5.0 |
| $Na_2O+K_2O$ | (mol %) | 17.0 | 17.0 | 15.0 | 20.0 |
| $K_2O/(Na_2O+K_2O)$ | | 0 | 0.24 | 0.27 | 0.50 |
| $Al_2O_3+SiO_2+B_2O_3$ | (mol %) | 75.0 | 73.0 | 79.0 | 73.0 |
| $(Na_2O+K_2O)/(Al_2O_3+SiO_2+B_2O_3)$ | | 0.227 | 0.233 | 0.190 | 0274 |
| Average thermal expansion coefficient ($\times 10^{-7}$/°C) | | 86 | 97 | 89 | 107 |
| Tg(°C) | | 643 | 600 | 551 | 618 |
| Specific gravity | | 2.50 | 2.50 | 2.41 | 2.51 |
| Alkali elution amount (1) | | (0.32) | (0.32) | (0.31) | (0.07) |
| Alkali elution amount (2) | | | | | |
| Na amount in Mo film (atoms/cc) | | 9.0E+20 | 6.9E+20 | 3.0E+20 | 4.81E+20 |
| K amount in Mo film (atoms/cc) | | 1.3E+18 | 8.5E+19 | 4.9E+19 | 1.49E+20 |
| $T_2$(°C) | | (1615) | | (1694) | (1678) |
| $T_4$(°C) | | (1172) | | (1219) | (1255) |
| Devitrification temperature (°C) | | < 1000 | < 1000 | < 1000 | 1175 |
| Cell efficiency (%) | | 14.01 | 15.35 | 14.94 | 14.10 |
| Voc(V/cm$^2$) | | 0.65 | 0.63 | 0.61 | 0.62 |
| Jsc(mA/cm$^2$) | | 29.08 | 31.16 | 31.04 | 30.69 |
| FF | | 0.68 | 0.67 | 0.67 | 0.63 |

[Table 4]

| | Ex. 15 | Ex. 16 | Ex. 17 | Ex. 18 | Ex. 19 |
|---|---|---|---|---|---|
| | mol % | mol % | mol % | mol % | mol % |
| $SiO_2$ | 64.2 | 67.0 | 61.0 | 63.5 | 74.0 |
| $Al_2O_3$ | 8.0 | 5.0 | 9.0 | 8.0 | 4.0 |
| $B_2O_3$ | 0 | 0 | 0 | 0 | 0 |
| MgO | 10.5 | 10.0 | 7.0 | 5.0 | 8.0 |
| CaO | 0.1 | 0 | 0 | 0 | 0 |
| SrO | 0.1 | 5.0 | 0 | 0 | 0 |
| BaO | 0.1 | 0 | 4.0 | 0.0 | 0 |
| $ZrO_2$ | 0.5 | 0 | 0 | 4.0 | 1.0 |
| $Na_2O$ | 12.5 | 7.0 | 16.0 | 18.5 | 11.0 |
| $K_2O$ | 4.0 | 6.0 | 3.0 | 1.0 | 2.0 |

(continued)

|  | Ex. 15 | Ex. 16 | Ex. 17 | Ex. 18 | Ex. 19 |
|---|---|---|---|---|---|
|  | mol % | mol % | mol % | mol % | mol % |
| $TiO_2$ | 0 | 0 | 0 | 0 | 0 |
| $SrO+BaO+ZrO_2$ | 0.7 | 5.0 | 4.0 | 4.0 | 1.0 |
| $MgO+CaO+SrO+BaO$ | 10.8 | 15.0 | 12.9 | 14.1 | 8.0 |
| $Na_2O+K_2O$ | 16.5 | 13.0 | 19.0 | 19.5 | 13.0 |
| $K_2O/(Na_2O+K_2O)$ | 0.24 | 0.46 | 0.16 | 0.05 | 0.15 |
| $Al_2O_3+SiO_2+B_2O_3$ | 72.2 | 72.0 | 70.0 | 71.5 | 78.0 |
| $(Na_2O+K_2O)/(Al_2O_3+SiO_2+B_2O_3)$ | 0.229 | 0.181 | 0.271 | 0.273 | 0.167 |
| Average thermal expansion coefficient ($\times 10^{-7}$/°C) | 98 | (87) | (105) | (97) | (76) |
| Tg(°C) | 608 | (593) | (586) | (589) | (597) |
| Specific gravity | 2.48 | (2.56) | (2.63) | (2.56) | (2.43) |
| Alkali elution amount (1) | (0.23) | (0.19) | (0.29) | (0.40) | (0.35) |
| Alkali elution amount (2) |  |  |  |  |  |
| Na amount in Mo film (atoms/cc) | (8.9E+20) | (3.2E+20) | (1.2E+21) | (1.1E+21) | (1.9E+20) |
| K amount in Mo film (atoms/cc) | (7.1E+19) | (6.7E+19) | (1.0E+20) | (7.5E+19) | (3.0E+19) |
| $T_2$(°C) | 1605 | (1562) | (1529) | (1560) | (1688) |
| $T_4$(°C) | 1181 | (1130) | (1112) | (1134) | (1195) |
| Devitrification temperature (°C) | <1154 |  |  |  |  |
| Cell efficiency (%) |  |  |  |  |  |
| Voc(V/cm$^2$) |  |  |  |  |  |
| Jsc(mA/cm$^2$) |  |  |  |  |  |
| FF |  |  |  |  |  |

[Table 5]

|  | Ex. 20 | Ex. 21 | Ex. 22 | Ex. 23 | Ex. 24 |
|---|---|---|---|---|---|
|  | mol % | mol % | mol % | mol % | mol % |
| $SiO_2$ | 65.9 | 64.0 | 61.0 | 64.0 | 64.0 |
| $Al_2O_3$ | 3.1 | 7.0 | 6.0 | 7.0 | 6.0 |
| $B_2O_3$ | 0 | 0 | 0 | 0 | 0 |
| MgO | 12.0 | 7.0 | 9.0 | 7.0 | 8.0 |
| CaO | 0 | 0 | 0 | 5.0 | 4.0 |
| SrO | 4.0 | 0 | 4.0 | 0 | 0 |
| BaO | 0.0 | 2.0 | 4.0 | 0 | 0 |
| $ZrO_2$ | 2.0 | 2.0 | 0 | 1.0 | 1.0 |
| $Na_2O$ | 10.0 | 14.0 | 12.0 | 13.0 | 14.0 |
| $K_2O$ | 3.0 | 4.0 | 4.0 | 3.0 | 3.0 |
| $TiO_2$ | 0 | 0 | 0 | 0 | 0 |
| $SrO+BaO+ZrO_2$ | 6.0 | 4.0 | 8.0 | 1.0 | 1.0 |
| $MgO+CaO+SrO+BaO$ | 16.0 | 8.0 | 10.0 | 6.5 | 8.0 |

(continued)

|  | Ex. 20 | Ex. 21 | Ex. 22 | Ex. 23 | Ex. 24 |
|---|---|---|---|---|---|
|  | mol % | mol % | mol % | mol % | mol % |
| $Na_2O+K_2O$ | 13.0 | 18.0 | 16.0 | 16.0 | 17.0 |
| $K_2O/(Na_2O+K_2O)$ | 0.23 | 0.22 | 0.25 | 0.19 | 0.18 |
| $Al_2O_3+SiO_2+B_2O_3$ | 69.0 | 71.0 | 67.0 | 71.0 | 70.0 |
| $(Na_2O+K_2O)/(Al_2O_3+SiO_2+B_2O_3)$ | 0.188 | 0.254 | 0.239 | 0.225 | 0.243 |
| Average thermal expansion coefficient ($\times 10^{-7}$/°C) | (84) | (99) | (102) | (94) | (97) |
| $Tg$(°C) | (585) | (593) | (582) | (592) | (577) |
| Specific gravity | (2.62) | (2.58) | (2.74) | (2.52) | (2.52) |
| Alkali elution amount (1) | (0.36) | (0.31) | (0.29) | (0.28) | (0.35) |
| Alkali elution amount (2) |  |  |  |  |  |
| Na amount in Mo film (atoms/cc) | (5.4E+20) | (7.6E+20) | (9.5E+20) | (1.3E+21) | (1.4E+21) |
| K amount in Mo film (atoms/cc) | (6.0E+19) | (1.1E+20) | (1.0E+20) | (4.8E+19) | (6.6E+19) |
| $T_2$(°C) | (1480) | (1566) | (1446) | (1530) | (1498) |
| $T_4$(°C) | (1085) | (1140) | (1066) | (1108) | (1081) |
| Devitrification temperature (°C) |  |  |  |  |  |
| Cell efficiency (%) |  |  |  |  |  |
| $Voc$(V/cm$^2$) |  |  |  |  |  |
| $Jsc$(mA/cm$^2$) |  |  |  |  |  |
| FF |  |  |  |  |  |

[Table 6]

|  | Ex. 25 | Ex. 26 | Ex. 27 | Ex. 28 | Ex. 29 |
|---|---|---|---|---|---|
|  | mol % | mol % | mol % | mol % | mol % |
| $SiO_2$ | 64.0 | 62.0 | 60.0 | 64.8 | 63.0 |
| $Al_2O_3$ | 6.0 | 5.0 | 10.0 | 5.0 | 7.0 |
| $B_2O_3$ | 3.0 | 2.0 | 0 | 0 | 0 |
| MgO | 6.0 | 7.0 | 5.0 | 12.9 | 7.0 |
| CaO | 2.0 | 0 | 1.0 | 0.3 | 0 |
| SrO | 1.0 | 2.0 | 2.0 | 0 | 0 |
| BaO | 1.0 | 2.0 | 2.0 | 0 | 0 |
| $ZrO_2$ | 2.0 | 4.0 | 1.5 | 0.5 | 3.0 |
| $Na_2O$ | 13.0 | 11.0 | 17.5 | 13.0 | 10.0 |
| $K_2O$ | 2.0 | 5.0 | 1.0 | 3.0 | 10.0 |
| $TiO_2$ | 0 | 0 | 0 | 0.5 | 0 |
| $SrO+BaO+ZrO_2$ | 4.0 | 8.0 | 5.5 | 0.5 | 3.0 |
| $MgO+CaO+SrO+BaO$ | 8.0 | 6.0 | 10.0 | 13.2 | 7.0 |
| $Na_2O+K_2O$ | 15.0 | 16.0 | 18.5 | 16.0 | 20.0 |
| $K_2O/(Na_2O+K_2O)$ | 0.13 | 0.31 | 0.05 | 0.19 | 0.50 |
| $Al_2O_3+SiO_2+B_2O_3$ | 73.0 | 69.0 | 70.0 | 69.8 | 70.0 |

(continued)

|  | Ex. 25 | Ex. 26 | Ex. 27 | Ex. 28 | Ex. 29 |
|---|---|---|---|---|---|
|  | mol % | mol % | mol % | mol % | mol % |
| $(Na_2O+K_2O)/(Al_2O_3+SiO_2+B_2O_3)$ | 0.205 | 0.232 | 0.264 | 0.229 | 0.286 |
| Average thermal expansion coefficient ($\times 10^{-7}$/°C) | (87) | (94) | (101) | (91) | (107) |
| Tg (°C) | (587) | (598) | (593) | (575) | (596) |
| Specific gravity | (2.56) | (2.68) | (2.65) | (2.50) | (2.51) |
| Alkali elution amount (1) | (0.32) | (0.31) | (0.29) | (0.36) | (0.19) |
| Alkali elution amount (2) |  |  |  |  |  |
| Na amount in Mo film (atoms/cc) | (1.7E+21) | (8.7E+20) | (1.4E+21) | (1.0E+21) | (3.8E+20) |
| K amount in Mo film (atoms/cc) | (1.7E+20) | (2.0E+20) | (6.0E+19) | (7.6E+19) | (1.7E+20) |
| $T_2$(°C) | (1524) | (1500) | (1514) | (1499) | (1592) |
| $T_4$(°C) | (1093) | (1109) | (1106) | (1081) | (1165) |
| Devitrification temperature (°C) |  |  |  |  |  |
| Cell efficiency (%) |  |  |  |  |  |
| Voc(V/cm$^2$) |  |  |  |  |  |
| Jsc(mA/cm$^2$) |  |  |  |  |  |
| FF |  |  |  |  |  |

As is clear from Tables 1 to 6, the glasses of the Examples (Examples 1, 2 and 5 to 29) are high in the alkali elution amount and high in the glass transition temperature Tg, and therefore, they are able to satisfy both high power generation efficiency and high glass transition temperature. Also, since the glasses of the Examples have an average thermal expansion coefficient of from $70 \times 10^{-7}$ to $110 \times 10^{-7}$/°C, at the time of assembling the solar cell of the present invention (specifically, when laminating a glass substrate having a photoelectric conversion layer of CIGS and a cover glass by heating), the glass sheet hardly causes deformation, and excellent power generation efficiency is revealed. The cell efficiency of Examples 15 to 29 is 14 % or more.

On the other hand, the expression "*" of the Comparative Example (Example 3) indicates that, in view of the fact that the glass of Example 3 is a general soda lime glass (glass transition temperature: 550°C), the glass is deformed by the heat treatment at 550°C for 30 minutes, so that the alkali elution amount cannot be measured. Accordingly, it may be considered that in the case of forming a photoelectric conversion layer of CIGS on a glass substrate, there is a concern that the glass is deformed, so that the photoelectric conversion layer cannot be formed. It may be considered that the Comparative Example (Example 4) is low in the alkali elution amount, and thus, the power generation efficiency is low.

While the glass sheet for a Cu-In-Ga-Se solar cell of the present invention is suitable for a glass substrate and a cover glass for a solar cell of CIGS, it can also be used for substrates or cover glasses for other solar cells.

While the invention has been described in detail and with reference to specific embodiments thereof, it will be apparent to one skilled in the art that various changes and modifications can be made therein without departing from the spirit and scope of the invention.

This application is based on Japanese Patent Application No. 2009-241330 filed on October 20, 2009, the contents of which are incorporated herein by reference.

Explanations of Letter or Numerals

1:    Solar cell
5:    Glass substrate
7:    Plus electrode
9:    CIGS layer

11:    Buffer layer
13:    Transparent conductive film
15:    Minus electrode
17:    Antireflection film
19:    Cover glass


**Claims**

1.  A glass sheet for a Cu-In-Ga-Se solar cell containing, in terms of mol % on the basis of the following oxides,
    from 60 to 75 % of $SiO_2$,
    from 3 to 10 % of $Al_2O_3$,
    from 0 to 3 % of $B_2O_3$,
    from 5 to 18 % of MgO,
    from 0 to 5 % of CaO,
    from 4 to 18.5 % of $Na_2O$,
    from 0 to 17 % of $K_2O$, and
    0 % or more and less than 10 % of $SrO + BaO + ZrO_2$,
    wherein $K_2O/(Na_2O + K_2O)$ is from 0 to 0.5, and
    the glass sheet has a glass transition temperature (Tg) of more than 550°C.

2.  The glass sheet for a Cu-In-Ga-Se solar cell according to claim 1, wherein, in terms of mol % on the basis of the following oxide, the content of CaO is from 0 to 3 %.

3.  The glass sheet for a Cu-In-Ga-Se solar cell according to claim 1 or 2, wherein, in terms of mol % on the basis of the following oxides,
    the content of SrO is from 0 to 5 %,
    the content of BaO is from 0 to 4 %, and
    the content of $ZrO_2$ is from 0 to 4 %.

4.  The glass sheet for a Cu-In-Ga-Se solar cell according to any one of claims 1 to 3, wherein, in terms of mol % on the basis of the following oxides, $SiO_2 + Al_2O_3 + B_2O_3$ is from 0 to 80 %.

5.  The glass sheet for a Cu-In-Ga-Se solar cell according to claim 4, wherein, in terms of mol % on the basis of the following oxides, $(Na_2O + K_2O)/(SiO_2 + Al_2O_3 + B_2O_3)$ is 0.15 or more.

6.  The glass sheet for a Cu-In-Ga-Se solar cell according to any one of claims 1 to 5, wherein an average thermal expansion coefficient is from $70 \times 10^{-7}$ to $110 \times 10^{-7}$/°C.

7.  A solar cell comprising a glass substrate including a photoelectric conversion layer of Cu-In-Ga-Se and a cover glass disposed on the glass substrate, wherein one or both of the glass substrate and the cover glass are the glass sheet for a Cu-In-Ga-Se solar cell according to any one of claims 1 to 6.

FIG. 1

| INTERNATIONAL SEARCH REPORT | International application No. |
|---|---|
| | PCT/JP2010/068526 |

A.   CLASSIFICATION OF SUBJECT MATTER
*C03C3/085*(2006.01)i, *C03C3/087*(2006.01)i, *C03C3/091*(2006.01)i, *C03C3/093*
(2006.01)i, *H01L31/04*(2006.01)i

According to International Patent Classification (IPC) or to both national classification and IPC

B.   FIELDS SEARCHED

Minimum documentation searched (classification system followed by classification symbols)
C03C1/00-14/00, H01L31/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)
INTERGLAD

C.   DOCUMENTS CONSIDERED TO BE RELEVANT

| Category* | Citation of document, with indication, where appropriate, of the relevant passages | Relevant to claim No. |
|---|---|---|
| P,X | JP 2010-59038 A  (Nippon Electric Glass Co., Ltd.), 18 March 2010 (18.03.2010), claims 1, 7, 10 to 12; paragraphs [0003], [0090]; tables 1, 2 | 1-7 |
| X | JP 2004-131314 A  (Asahi Glass Co., Ltd.), 30 April 2004 (30.04.2004), claims 1, 3, 4; paragraph [0035]; table 1 | 1-7 |
| X | JP 2008-115072 A  (Nippon Electric Glass Co., Ltd.), 22 May 2008 (22.05.2008), claim 1; paragraph [0103]; table 5 | 1-7 |

| ☒ | Further documents are listed in the continuation of Box C. | ☒ | See patent family annex. |
|---|---|---|---|

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 13 January, 2011 (13.01.11) | 25 January, 2011 (25.01.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| International application No. |
| --- |
| PCT/JP2010/068526 |

C (Continuation).   DOCUMENTS CONSIDERED TO BE RELEVANT

| Category* | Citation of document, with indication, where appropriate, of the relevant passages | Relevant to claim No. |
| --- | --- | --- |
| X | JP 2004-43295 A  (Nippon Sheet Glass Co., Ltd.), 12 February 2004 (12.02.2004), claims 6, 8, 9; paragraph [0056]; tables 1 to 4 | 1-7 |

Form PCT/ISA/210 (continuation of second sheet) (July 2009)

| INTERNATIONAL SEARCH REPORT<br>Information on patent family members | International application No.<br>PCT/JP2010/068526 |
|---|---|

| | | |
|---|---|---|
| JP 2010-59038 A | 2010.03.18 | (Family: none) |
| JP 2004-131314 A | 2004.04.30 | (Family: none) |
| JP 2008-115072 A | 2008.05.22 | US 2010/0035745 A<br>EP 2075237 A1<br>WO 2008/044694 A1<br>KR 2009-0027259 A<br>CN 101522584 A |
| JP 2004-43295 A | 2004.02.12 | US 2003/0220183 A1<br>US 2008/0053152 A1 |

Form PCT/ISA/210 (patent family annex) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11013519 A
- JP 2009241330 A